# FASCICULE DE BREVET EUROPEEN

(11) **EP 0 442 829 B1**
(45) Date de publication et mention de la délivrance du brevet: **24.05.1995**
(21) Numéro de dépôt: 91420042.3
(22) Date de dépôt: 08.02.1991
(51) Int. Cl.: H03K 5/00, H03K 5/15

(54) **Doubleur de fréquence d'horloge**
Taktfrequenzverdoppler
Clock frequency doubler

(30) Priorité: 13.02.1990 FR 9002216
(43) Date de publication de la demande: 21.08.1991
(73) Titulaire: SGS-THOMSON MICROELECTRONICS S.A., 94250 Gentilly (FR)
(72) Inventeur: Artieri, Alain, F-38240 Meylan (FR); Kritter, Sylvain, F-38000 Grenoble (FR)
(74) Mandataire: de Beaumont, Michel

(56) Documents cités:
- FR-A- 2 379 198
- IBM TECHNICAL DISCLOSURE BULLETIN, vol. 29, no. 1, juin 1986, pages 263-264,New York, US; "Non-overlapping clock generator"
- ELECTRICAL DESIGN NEWS, vol. 17, no. 24, 15 décembre 1972, page 41, Newton, MA,US; D. GIBONEY: "Double-edge pulser uses few parts"

## Description

La présente invention concerne la génération de signaux d'horloge complémentaires à phase non-recouvrantes et à la fréquence double d'un signal d'horloge d'entrée.

Avant de décrire la présente invention on va rappeler le fonctionnement d'un générateur d'horloge à phases non-recouvrantes comprenant une bascule à portes NON ET, appelées ci-après bascule NAND. On notera que cette bascule se distingue d'une bascule RS classique réalisée à partir de portes NON OU.

La figure 1A représente schématiquement une bascule NAND 1 comprenant deux bornes d'entrée E1 et E2 et deux sorties complémentaires Q* et Q. Cette bascule comprend deux portes NON ET A1 et A2. La porte A1 est connectée par sa première entrée à la borne E1 et par sa deuxième entrée à la sortie Q de la porte A2. La porte A2 est connectée par sa première entrée à la borne E2 et par sa deuxième entrée à la sortie Q* de la porte A1. Les entrées E1 et E2 reçoivent respectivement un signal d'horloge CLK et le signal complémentaire CLK*.

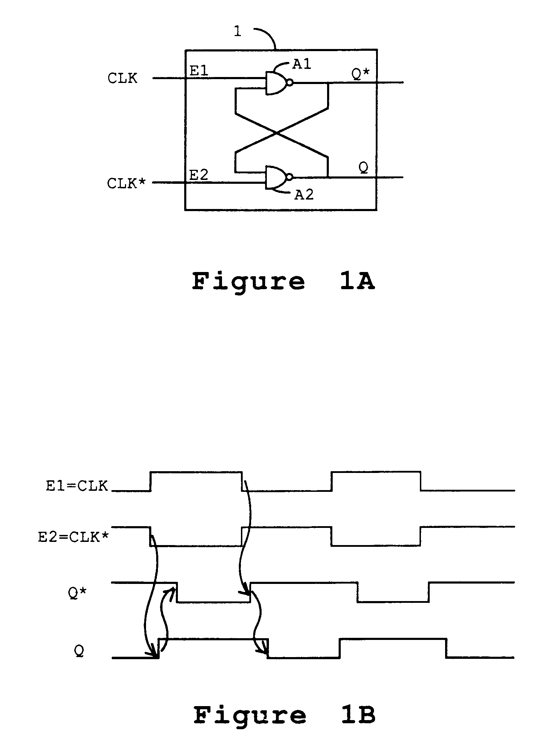

La figure 1B représente l'allure des signaux aux entrées et aux sorties. Si l'on part d'un état où l'horloge d'entrée CLK est basse, CLK* est haut, Q* est haut et Q est bas. Quand CLK* passe à niveau bas, la porte NON ET A2 change d'état et le signal Q passe à haut niveau après un retard dépendant de la structure de la porte A1. Ce basculement de la sortie Q provoque le basculement de la porte A1 et le signal Q* passe à bas niveau après un deuxième retard.

On notera, comme cela est connu dans la technique, que le retard apporté par un basculement haut/bas tel que celui subi par la sortie Q* peut être différent du retard lié à un basculement bas/haut tel que celui subi par la sortie Q.

Ensuite, quand le signal CLK* passe à haut niveau, c'est le passage à bas niveau du signal CLK qui provoque le basculement de la porte A1 et le passage à haut niveau de la sortie Q* après le premier retard, tandis que la porte A2 bascule ensuite après le deuxième retard pour faire passer à niveau bas la sortie Q. On obtient donc bien des signaux Q et Q* de même période que les signaux d'horloge d'entrée CLK et CLK* mais les phases pendant lesquelles ces signaux Q et Q* se trouvent à niveau bas ne se recouvrent pas. On dit que l'on a généré des signaux d'horloge à phases basses non-recouvrantes.

Un objet de la présente invention est de prévoir un circuit particulièrement simple et complètement intégrable permettant à partir d'un signal d'horloge d'entrée de fournir des signaux d'horloge complémentaires à fréquence double et à phases non-recouvrantes.

Un autre objet de la présente invention est de prévoir un circuit simple et intégrable permettant de fournir à partir d'un signal d'horloge d'entrée, d'une part des signaux d'horloge à la même fréquence à phases non-recouvrantes et d'autre part des signaux d'horloge à fréquence double à phases non-recouvrantes, une relation de phase déterminée étant établie entre les signaux à fréquence simple et à fréquence double.

Pour atteindre ces objets, la présente invention prévoit un circuit de génération de signaux d'horloge complémentaires à phases non-recouvrantes et à fréquence double à partir d'un signal d'horloge d'entrée, comprenant une bascule NAND à portes NON ET et à sorties complémentaires sur lesquelles sont disponibles les signaux à fréquence double ; une bascule de type D recevant sur son entrée d'horloge l'une des sorties de la bascule NAND et dont la sortie est couplée à son entrée de données par un inverseur ; et deux portes OU Exclusif recevant sur leurs premières entrées respectivement le signal d'horloge d'entrée et son complément et sur leur deuxième entrée la sortie de la bascule de type D et dont les sorties sont respectivement connectées aux entrées de la bascule NAND.

Ces objets, caractéristiques et avantages ainsi que d'autres de la présente invention seront exposées plus en détail dans la description suivante de modes de réalisation particuliers faites en relation avec les figures jointes parmi lesquelles :
la figure 1A, précédemment décrite, représente une bascule NAND permettant la génération de signaux d'horloge complémentaires à phases basses non-recouvrantes ;
la figure 1B illustre les signaux apparaissant aux entrées et aux sorties du circuit de la figure 1A ;
la figure 2A représente un circuit doubleur de fréquence d'horloge à phases basses non-recouvrantes selon la présente invention ;
la figure 2B illustre des signaux apparaissant en différents points du circuit de la figure 2A ;
la figure 3A représente un circuit de fourniture de signaux d'horloge à fréquence simple et à fréquence double, chacune de ces horloges étant à phases non-recouvrantes et une synchronisation étant assurée entre les signaux à fréquence simple et double ; et
La figure 3B illustre des signaux apparaissant en divers points du circuit de la figure 3A.

Dans la plupart des figures ci-jointes, on a représenté les signaux comme parfaitement rectangulaires. En fait, l'homme de l'art notera que chacun de ces signaux présente une certaine pente lors des transitions d'état haut à état bas et inversement.

La figure 2A représente un doubleur de fréquence selon la présente invention. Ce doubleur de fréquence comprend une bascule NAND 2 et une bascule de type D 3. La bascule 2 est constituée de la façon illustrée en figure 1A. La sortie Q* de la bascule 2 est connectée à l'entrée d'horloge H de la bascule de type D 3 par l'intermédiaire d'un inverseur I1. La sortie de données Q_{D} de la bascule 3 est reliée à son entrée de données D par l'intermédiaire d'un inverseur I2. La sortie Q_{D} est également reliée aux deuxièmes entrées de portes OU Exclusif XO1 et XO2 dont les premières entrées reçoivent respectivement des signaux d'horloge d'entrée CLK* et CLK. La sortie de la porte XO1 est reliée à l'entrée E1 de la bascule 2 et la sortie de la porte XO2 est reliée à l'entrée E2 de cette bascule.

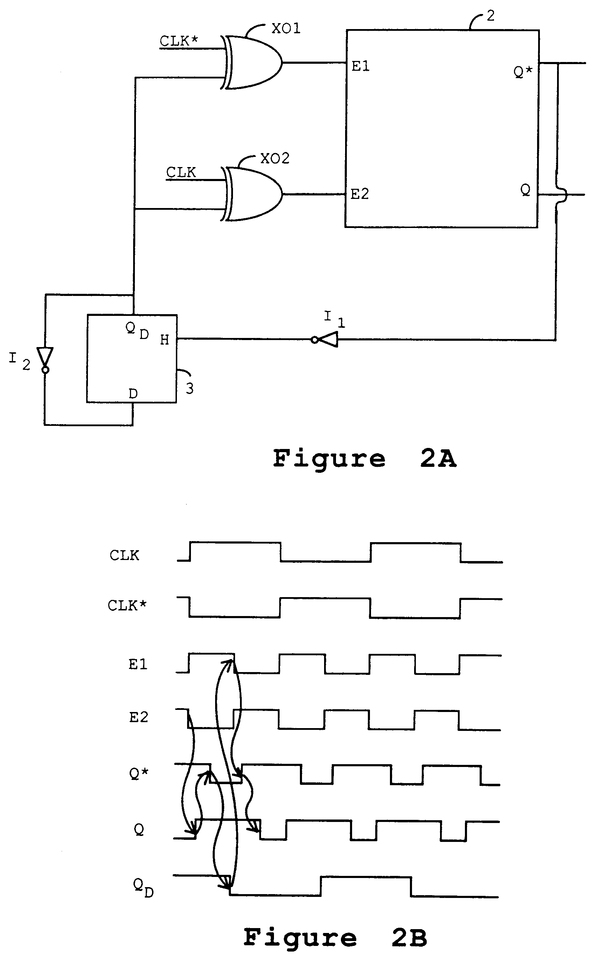

Le fonctionnement de ce circuit va être expliqué en relation avec la figure 2B. On part d'un état initial dans lequel le signal CLK est à niveau bas, le signal CLK* haut, l'entrée E1 basse, l'entrée E2 haute, la sortie Q* haute, la sortie Q basse et la sortie Q_{D} haute. Comme dans le cas de la figure 1B, le passage à niveau bas de l'entrée E2 provoque après un premier retard le passage à niveau haut de la sortie Q puis après un deuxième retard le passage à niveau bas de la sortie Q*. Ce passage à niveau bas de la sortie Q* amène la bascule de type D à fournir sur sa sortie Q_{D} l'état correspondant au signal sur son entrée D, c'est-à-dire que, après un troisième retard, qui dépend du temps de transfert de la bascule D, la sortie Q_{D} passe de niveau haut à niveau bas. Si l'on suppose que les portes OU Exclusif XO1 et XO2 n'introduisent aucun retard, ceci entraîne une commutation des entrées E1 et E2. Alors, de la même façon que cela a été décrit en relation avec la figure 1B, le passage à bas niveau de l'entrée E1 provoque après le premier retard un passage à niveau haut de la sortie Q* puis un passage à niveau bas de la sortie Q. La commutation suivante est associée au changement d'état des signaux CLK et CLK*.

On a donc obtenu des signaux d'horloge Q* et Q à phases basses non-recouvrantes et à fréquence double de la fréquence d'horloge CLK.

On a représenté les transitions intermédiaires des signaux E1 et E2 au milieu des intervalles d'horloge. Ceci n'est pas réellement le cas car, comme cela a été indiqué, ces transitions intermédiaires résultent de la somme de 3 retards.

Un avantage de la présente invention réside dans le fait que les diverses bascules utilisées sont toutes réalisées selon la même technologie sur un même circuit intégré. Il se produira donc une auto-régulation du système quand les conditions extérieures (températures, ...) ou les conditions de fabrication varient. En particulier, la durée du passage à bas niveau du signal Q* qui dépend essentiellement du temps de transfert de la bascule D sera nécessairement suffisante pour la commande d'autres circuits de même type.

On notera qu'une autre façon de décrire le circuit ci-dessus, consiste à remarquer que le signal Q_{D} est un signal présentant un retard de phase par rapport au signal CLK. Il est connu dans l'art antérieur d'obtenir des signaux à fréquence double par combinaison d'un signal d'horloge et de ce même signal d'horloge déphasé. Toutefois, les circuits de l'art antérieur impliquent l'utilisation de circuits de retard qui sont complexes à fabriquer et qui nécessitent généralement des composants externes à un circuit intégré tels que des capacités de fortes valeurs. La solution selon la présente invention permet d'obtenir le même résultat avec un montage particulièrement simple, occupant peu de surface sur un circuit intégré, pour lequel aucun composant externe n'est nécessaire et qui est autorégulé vis-à-vis des variations de technologie et d'environnement.

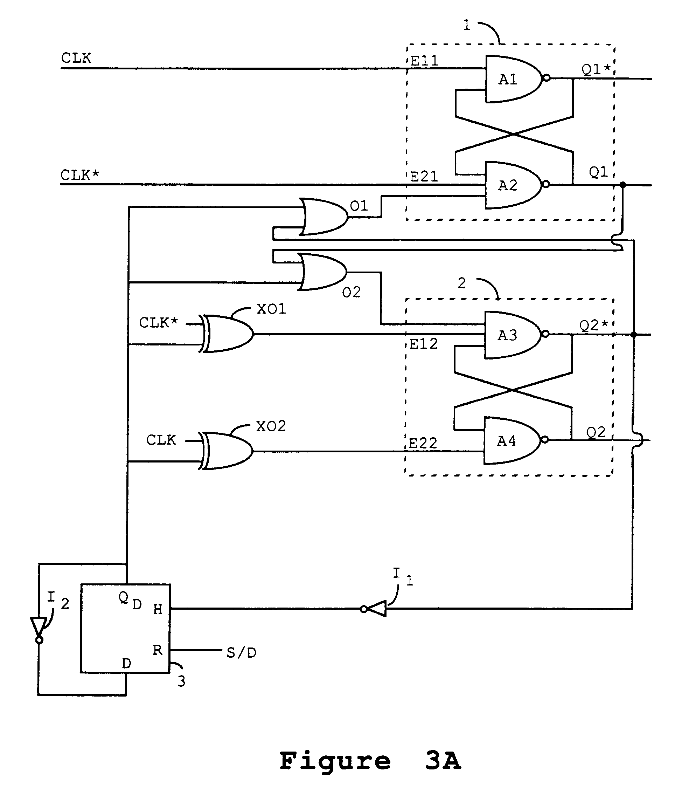

La figure 3A illustre un autre aspect de la présente invention selon lequel on cherche à obtenir des signaux à une première fréquence et à la fréquence double, chacun de ces signaux étant à phases non-recouvrantes, et les signaux à fréquence double présentant un décalage de phase donné par rapport aux signaux à fréquence simple, par exemple pour l'un de leurs fronts montants ou l'un de leurs fronts descendants.

Par exemple, dans le cadre d'une application à un système de traitement de données, on souhaite parfois convertir des mots de définition donnée, par exemple des mots de 8 bits, en des mots de définition double, par exemple des mots de 16 bits, pour effectuer des calculs rapides et précis puis garder ensuite les 8 bits les plus significatifs du mot de 16 bits. Il convient alors d'écrire dans des registres décalés à fréquence double à partir de registres décalés à fréquence simple. Pour cela, il faut que le front montant de la première impulsion à fréquence double arrive avant le front descendant de la deuxième impulsion à fréquence simple. Inversement, si l'on veut un bon fonctionnement en écriture dans un registre à fréquence simple par le contenu d'un registre à fréquence double, il faut que le front montant de la première impulsion à fréquence simple arrive avant le front descendant de la deuxième impulsion à fréquence double.

Pour atteindre un tel résultat, on peut associer un générateur d'impulsions d'horloge complémentaires à fréquence simple sans recouvrement de phase tel que celui de la figure 1A à un générateur d'impulsions d'horloge complémentaires à fréquence double sans recouvrement de phase tel que celui de la figure 2A de la façon illustrée en figure 3A, en rajoutant une condition de validation supplémentaire sur l'une des portes NON ET de chacune des bascules NAND 1 et 2. Cette condition supplémentaire est imposée de la façon illustrée dans la figure par des portes OU O1 et O2 dont une entrée reçoit la sortie Q_{D} de la bascule 3. La sortie de chaque porte OU est appliquée à l'entrée de celle des portes NON ET dont la sortie doit être asservie et chaque porte OU reçoit sur sa deuxième entrée la sortie de la porte NON ET de l'autre bascule sur laquelle on veut obtenir l'asservissement.

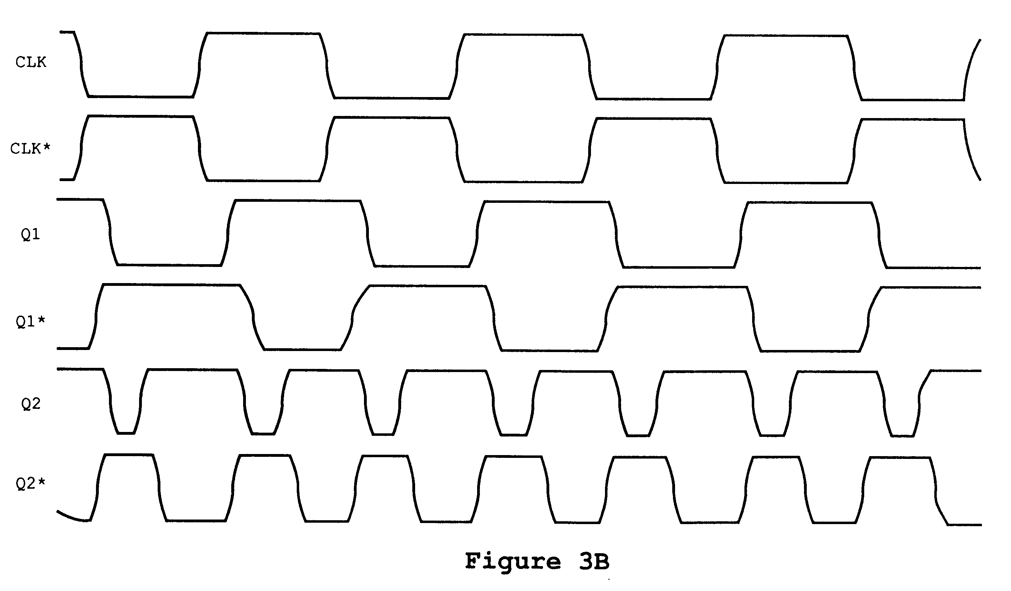

La figure 3B illustre l'allure de signaux obtenus avec le circuit de la figure 3A. Q1 et Q1* désignent les sorties de la bascule 1 et Q2 et Q2* les sorties de la bascule 2. On notera que ces sorties sont sans recouvrement à niveau bas et l'on obtient les relations de phase mutuelles souhaitées.

On notera également dans la figure 3A que la bascule 3 de type D est munie d'une entrée de remise à zéro R sur laquelle est appliqué un signal S/D (simple fréquence/double fréquence). Si ce signal S/D ne valide pas l'entrée de remise à zéro de la bascule 3, le fonctionnement est tel que décrit précédemment. Si ce signal S/D applique en permanence un signal de remise à zéro à la bascule 3, l'état de la sortie Q_{D} ne varie pas et on notera qu'alors la bascule 2 fournit des signaux à fréquence simple et à phases non-recouvrantes comme la bascule 1. Ce montage permet d'obtenir deux couples de signaux à fréquence simple sans recouvrement de phase et avec une relation de phase déterminée entre chacun des couples.

## Revendications

1. Circuit de génération de signaux d'horloge complémentaires à phases non-recouvrantes et à fréquence double à partir d'un signal d'horloge d'entrée, comprenant une bascule RS (2) à portes NON ET et à sorties complémentaires sur lesquelles sont disponibles les signaux à fréquence double, caractérisé en ce qu'il comprend en outre :
une bascule de type D (3) recevant sur son entrée d'horloge (H) l'une des sorties de la bascule RS et dont la sortie (Q_{D}) est couplée à son entrée de données (D) par un inverseur (I2) ; et
deux portes OU Exclusif (XO1, XO2) recevant sur leurs premières entrées respectivement le signal d'horloge d'entrée et son complément et sur leur deuxième entrée la sortie de la bascule de type D et dont les sorties sont respectivement connectées aux entrées (E1 et E2) de la bascule RS.

2. Circuit de génération de signaux d'horloge complémentaires (Q2, Q2*) à phases non-recouvrantes et à fréquence double d'un signal d'horloge d'entrée, ces signaux d'horloge à fréquence double présentant une relation de phase déterminée par rapport à des signaux d'horloge complémentaires (Q1, Q1*) à phases non-recouvrantes à la fréquence d'entrée, caractérisé en ce qu'il comprend :
- un circuit doubleur selon la revendications 1,
- un circuit classique à bascule RS de génération de signaux d'horloge complémentaires à phases non-recouvrantes, et
- des moyens (O1, O2) de validation de l'une des entrées de chacune des bascules RS pour valider cette entrée quand l'une des sorties de l'autre bascule RS a commuté.

3. Circuit selon l'une quelconque des revendications 1 ou 2, caractérisé en ce que les bascules RS (1, 2) sont constituées de sorte que les commutations d'un état haut à un état bas ne présentent pas le même retard que les commutations d'un état bas à un état haut.

## Patentansprüche

1. Schaltung zum Erzeugen von sich nicht überlappenden komplementären Taktsignalen doppelter Frequenz aus einem Eingangstaktsignal, mit einem RS-Flip-Flop (2), welches NAND-Gatter und komplementäre Ausgänge aufweist, an denen die Signale doppelter Frequenz verfügbar sind, gekennzeichnet durch die weiteren Merkmale:
ein D-Flip-Flop (3), welches an seinem Takteingang (H) einen der Ausgangssignale des RS-Flip-Flops empfängt und dessen Ausgang (Q_{D}) mit seinem Dateneingang (D) über einen Inverter (I2) verbunden ist, und
zwei Exklusiv-ODER-Gatter (XO1, XO2), welche an ihren ersten Eingängen das Eingangstaktsignal und sein Komplement empfangen und an ihren zweiten Eingängen den Ausgang des D-Flip-Flops empfangen und deren Ausgänge jeweils mit den Eingängen (E1 und E2) des RS-Flip-Flops verbunden sind.

2. Schaltung zum Erzeugen von sich nicht überlappenden komplementären Taktsignalen (Q2, Q2*) doppelter Frequenz aus einem Eingangstaktsignal, wobei die Signale doppelter Frequenz eine vorgegebene Phasenbeziehung zu sich nicht überlappenden komplementären Taktsignalen (Q1, Q1*) der Eingangsfrequenz haben, gekennzeichnet durch die folgenden Merkmale:
- eine Verdopplungsschaltung nach Anspruch 1,
- eine klassische RS-Flip-Flop-Schaltung zum Erzeugen von sich nicht überlappenden komplementären Taktsignalen und
- Freigabemittel (01, 02) für einen Eingang jedes RS-Flip-Flops, um diesen Eingang freizugeben, wenn einer der Ausgänge des anderen RS-Flip-Flops umgeschaltet hat.

3. Schaltung nach einem der Ansprüche 1 oder 2, dadurch gekennzeichnet, daß die RS-Flip-Flops (1, 2) so gestaltet sind, daß das Umschalten von einem hohen Pegel auf einen niedrigen Pegel nicht dieselbe Verzögerung hat wie das Umschalten von einem niedrigen Pegel auf einen hohen Pegel.

## Claims

1. A circuit for generating non-overlapping complementary clock signals at a double frequency from an input clock signal, comprising an RS flip-flop (2) with NAND gates and complementary outputs on which said double frequency signals are available, characterized in that it further comprises:
a D-type flip-flop (3) having a data input, a clock input and an output receiving at its clock input (H) one of the outputs of the RS flip-flop, and the output (QD) of which is coupled to its data input (D) through an inverter (I2); and
two Exclusive OR gates (XO1, XO2) receiving on their first inputs the input clock signal and its complement, respectively, and on their second inputs the output of the D-type flip-flop, the outputs of said OR gates being connected to the inputs (E1 and E2) of said RS flip-flop, respectively.

2. A circuit for generating non-overlapping complementary clock signals (Q2, Q2*) at a double frequency from an input clock signal, said double frequency clock signals having a determined phase relationship with respect to non-overlapping complementary clock signals (Q1, Q1*) at the input frequency, characterized in that it comprises:
- a doubling circuit according to claim 1,
- a conventional RS flip-flop circuit for generating non-overlapping complementary clock signals, and
- enabling means (01, 02) of one input of each RS flip-flop for enabling said one input when one of the outputs of the other RS flip-flop is switched.

3. A circuit according to claim 1 or 2, characterized in that the RS flip-flops (1, 2) are such that switchings from high level to low level have not the same delay as switchings from low level to high level.
